(19) Europäisches Patentamt European Patent Office Office européen des brevets

(11) EP 2 693 501 B1

(12) **EUROPEAN PATENT SPECIFICATION**

(45) Date of publication and mention
of the grant of the patent:
**26.04.2017 Bulletin 2017/17**

(51) Int Cl.:
$H01L\ 35/00\ ^{(2006.01)}$    $H01L\ 37/00\ ^{(2006.01)}$

(21) Application number: **13178334.2**

(22) Date of filing: **29.07.2013**

(54) **Thin-film structure with asymmetric ballistic conductance**

Dünnfilmstruktur mit asymmetrischer ballistischer Leitfähigkeit

Structure en couche mince à conductance balistique asymétrique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.08.2012 US 201213565065**

(43) Date of publication of application:
**05.02.2014 Bulletin 2014/06**

(73) Proprietor: **Hamilton Sundstrand Corporation
Windsor Locks, CT 06096-1010 (US)**

(72) Inventors:
• **Mantese, Joseph V.
Ellington, CT 06029 (US)**
• **Landry, Eric S.
West Hartford, CT 06107 (US)**
• **Culp, Slade R.
Coventry, CT 06238 (US)**

(74) Representative: **Bridge, Kerry Ann
Dehns
St Bride's House
10 Salisbury Square
London EC4Y 8JD (GB)**

(56) References cited:
**EP-A2- 2 157 625    WO-A1-2013/047253
US-A- 3 343 009**

**EP 2 693 501 B1**

**Description**

BACKGROUND

The present invention relates generally to thermoelectric materials, and more particularly to a solid state thermoelectric structure with asymmetric ballistic conductance.

The ability to control the direction and magnitude of energy flow in one dimension (wire), two dimension (thin film), and three dimension (bulk) solid state components has been considered critical to device performance since the beginning of the electronic age. Directionality of thermal and electrical currents is a critical concern in thermoelectric devices, diodes, and other electronic valves. The dimensionless thermoelectric figure of merit, a measure of thermoelectric performance, is defined as

$$ZT = \frac{S^2 \sigma T}{\kappa},$$  [Equation 1]

where S, $\sigma$, $\kappa$ and T are the Seebeck coefficient, electrical conductivity, thermal conductivity and absolute temperature respectively. The best bulk thermoelectric materials have $ZT\sim1.0$ near room temperature, although there have recently been reports of p-type materials having $ZT\sim1.8$. Materials with $ZT\sim1.5$ have been demonstrated at higher temperatures. It is generally recognized that materials must exhibit at least $ZT\sim2$ for thermoelectric devices to be viable for solid-state cooling, and that $ZT\sim5$ is necessary to significantly impact commercial and military markets.

Thin film semiconductor and semi-metals show promise for substantial gains in $ZT$. Power factor ($S^2\sigma$) in thin films can be increased due to charge confinement in an effectively two-dimensional film, and the resulting quantum mechanical peak in the electron density of states. If $\sigma$ is increased while $\kappa$ is decreased, $ZT$ may be further improved. Unfortunately, increases in electrical conductivity $\sigma$ (which typically arise due to increased dopant concentration) tend to lead to a corresponding increase in thermal conductivity $\kappa$, as thermal energy in a semiconductor is carried by both electrons and phonons (i.e., quantized lattice vibrations). According to the Wiedemann-Franz law, the ratio between $\sigma$ and the electronic contribution to the thermal conductivity, $\kappa_{el}$, is where $L$ is the Lorentz number. Because the Lorentz number is constant for most materials, the ratio $\sigma/\kappa_{el}$ is generally assumed to be fixed. Fortunately, the electrical conductivity and thermal conductivity appearing in Equation 1 correspond to opposite directions of carrier transport in the thermoelectric material. The relevant direction for the electrical conductivity is the direction in which the applied electric field drives charge (i.e. the forward current direction). The relevant direction for the thermal conductivity is the direction in which the temperature gradient drives charge (i.e. the reverse current direction). Thus, in the limit of zero phonon contribution to thermal transport,

$$ZT = \frac{S^2}{L} \frac{\sigma_{forward}}{\sigma_{reverse}}.$$  [Equation 3]

Improvements in $ZT$ can be realized if the ratio between forward and reverse electrical conductivities $\sigma_{forward}/\sigma_{reverse}$ is maximized. One method for producing materials with $\sigma_{forward}/\sigma_{reverse}>1$ by creating a series of asymmetric inclusions to alter current flow was presented in U.S. Patent application US2010/0044644 A1 entitled, "Composite Material with Anisotropic Electrical and Thermal Conductivities," filed August 19. 2008.

EP2157625 describes a thermoelectric structure including curved scattering guides.

SUMMARY

A thermoelectric structure comprises a thin thermoelectric film extending in a plane between parallel first and second shorting bars. A plurality of curved ballistic scattering guides are formed in a magnetic field region of the thin thermoelectric film subjected to a local, substantially uniform, nonzero magnetic field normal to the plane of the thin thermoelectric film.

BRIEF DESCRIPTION OF THE DRAWINGS

FIG. 1 is a schematic view of a thermoelectric structure according to the present invention.

FIG. 2A is an illustrative trajectory plot of forward charge transport through the thermoelectric structure of FIG. 1.
FIG. 2B is an illustrative trajectory plot of reverse charge transport through the thermoelectric structure of FIG. 1.

DETAILED DESCRIPTION

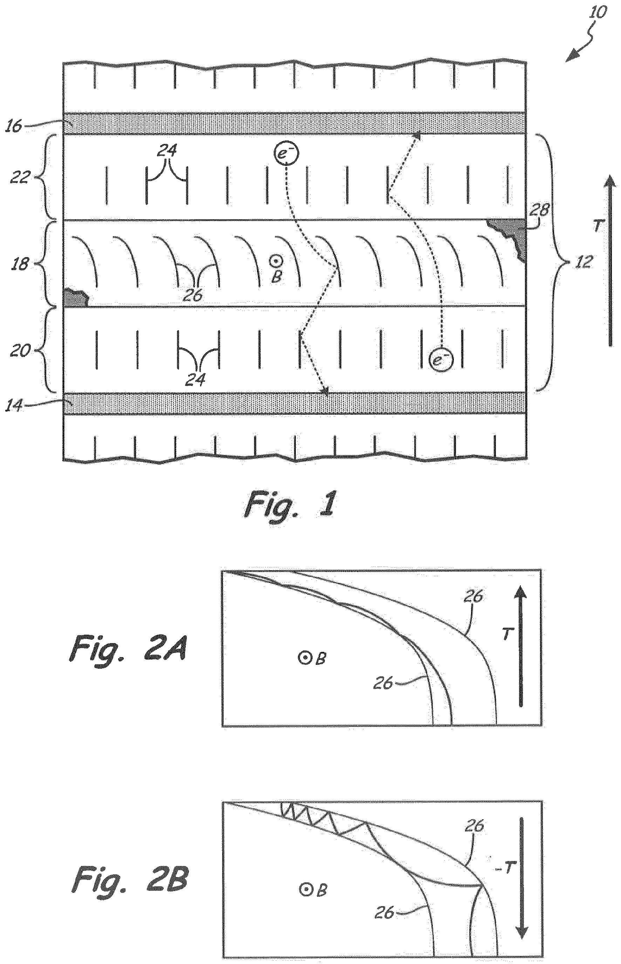

FIG. 1 is a schematic diagram of thermoelectric structure 10. FIG. 1 depicts asymmetric conductance region 12, shorting bars 14 and 16, magnetic field region 18, collimating regions 20 and 22, collimating guides 24, curved guides 26, and magnetic material 28.

Thermoelectric structure 10 is a substantially two-dimensional thermal diode formed on a thin semiconductor or semi-metal film. Thermoelectric structure 10 may be formed atom layer by atom layer by physical vapor deposition (PVD) methods such as molecular beam epitaxy (MBE), ion beam deposition (IBD), electron beam deposition (EBD), and others known to those skilled in the art. Thermoelectric structure 10 may, for instance, be formed of a high-mobility semiconductor or semi-metal such as graphene, gallium nitride, or silicon carbide, and has a thickness less than the mean free path of an electron in the material. Thermoelectric structure 10 includes at least one asymmetric conductance region 12 defined between shorting bars 14 and 16. Shorting bars 14 and 16 are thin regions of conductive material such as doped graphene or deposited layers of a conductor such as platinum or gold formed in or on thermoelectric structure 10. Shorting bars 14 and 16 act as electrodes, and collect charges passing through asymmetric conductance region 12. Thermoelectric structure 10 may comprise a plurality of repeating asymmetric conductance regions 12 arranged sequentially end-to-end in series, each separated from the next by a shorting bar. Similarly, a plurality of thermoelectric structures 10 can be stacked atop one another with intermediate isolating layers to form a three dimensional composite structure.

Magnetic field region 18 is a band of asymmetric conductance region 12 subjected to a localized magnetic field **B** oriented normal to the plane of thermoelectric structure 10 and out of the page, as depicted in FIG. 1. This magnetic field is provided by depositing and polarizing magnetic material 28, a thin layer of magnetic material located atop and/or beneath the plane of thermoelectric structure 10, adjacent magnetic field region 18. Magnetic field **B** is herein assumed for simplicity to be substantially uniform within magnetic field region 18, although all implementations of magnetic field **B** will of course vary somewhat over magnetic field region 18. Collimating regions 20 and 22 are bands of asymmetric conductance region 12 situated between magnetic field region 18 and shorting bars 14 and 16, respectively. Collimating regions 20 and 22 are regions with negligible magnetic field that serve to collimate ballistic charge flow between shorting bars 14 and 16 (in either direction).

Collimating regions 20 and 22 feature collimating guides 24, while magnetic field region 18 features curved guides 26. Collimating guides 24 and curved guides 26 are physical discontinuities along lines in thermoelectric structure 10 that act as scattering barriers to form channels in collimating regions 20 and 22 and magnetic field region 18, respectively, by ballistically scattering incident charge carriers. Adjacent collimating guides 24 may, for instance, be separated by a distance of approximately 1nm - approximately 1μm along an axis parallel to shorting bars 14 and 16, depending on the material and operating temperature of thermoelectric structure 10. Adjacent curved guides are separated by a similar distance. Collimating guides 24 and curved guides 26 may be created in a variety of ways, including by laser or mechanical scribing, surface level doping, field doping, or lithographic patterning. Collimating guides 24 are straight, parallel lines that act to focus charge carrier trajectories in collimating regions 20 and 22 along transport direction T or the opposite direction, -T. Curved guides 26 focus charge carriers moving in transit direction T from shorting bar 14 to shorting bar 16, but act to continually frustrate charge transport in opposite direction -T, as described in further detail below. Collimating guides 24 and curved guides 26 extend throughout the entire thickness of thermoelectric structure 10.

It is well known from elementary physics that a charge carrier of charge $q$, when travelling with vector velocity **v** through a magnetic field characterized by vector **B**, will experience a Lorentz force:

$$\mathbf{F} = q\mathbf{v} \times \mathbf{B}. \qquad\qquad [\text{Equation 4}]$$

A charge travelling in a plane through a magnetic field normal to that plane thus experiences a Lorenz force $q\mathbf{v}B$ in the plane and at right angles with **v**. The direction of curvature of a charge trajectory due to Lorenz force is opposite for conductors travelling with velocities **v** and -**v**, and of opposite signs $q$ and -$q$. As depicted in FIG. 1, an electron travelling in transport direction T will deflect to the left under magnetic field **B**, while an electron travelling in the opposite direction -T will deflect to the right under magnetic field **B**. Curved guides 26 take advantage of this broken symmetry by allowing substantially unobstructed electron flow in transit direction T while frustrating electron flow in the opposite direction -T. Curved guides 26 form parallel curved channels in magnetic field region 18 that coincide with the arcs of curvature of forward conduction (i.e. in transit direction T), and thus more closely match the natural deflection trajectories of negative charge carriers moving in transit direction T than in the opposite direction -T. Thus, electrons travelling in transport direction T scatter on curved guides 26 substantially less and at wider angles than electrons travelling in the opposite direction -T. This asymmetry results in longer ballistic trajectories in the -T direction than in transmit direction T, with corresponding forward electrical conductivity $\sigma_{forward}$ > reverse electrical conductivity $\sigma_{reverse}$. This behavior is illustrated and described in further detail with respect to FIGs. 2A and 2B.

FIGs. 2A and 2B depict ballistic trajectories of negative charge carriers such as electrons through magnetic field region 18. FIG. 2A shows the trajectory of a charge carrier moving in transport direction T, while FIG. 2B shows the trajectory of a charge carrier moving in opposite direction -T. In both cases the Lorentz force causes the charge carrier to deflect in a counter-clockwise direction, according to the right-hand rule. In FIG. 2A, the charge carrier is deflected substantially to the right along a path defined by curved guides 26, and scatters at large angles with respect to curved guide 26. This scattering adds relatively little to the total path length of the charge carrier trajectory in FIG. 2A, corresponding to a high value of forward electrical conductivity $\sigma_{forward}$. In FIG. 2B, by contrast, the charge carrier is deflected substantially to the right, and scatters several times at progressively smaller angles with respect to curved guides 26. This scattering dramatically lengthens the total path length of the charge carrier trajectory in FIG. 2B, corresponding to a low value of reverse electrical conductivity $\sigma_{reverse} < \sigma_{forward}$.

Thermoelectric structure 10 enables high values of *ZT*. Magnetic field regions 18 with perpendicularly applied magnetic fields **B** and curved guides 26 coinciding with arcs of curvature of charge carriers traveling in transport direction T can yield ratios of forward to reverse conductance $\sigma_{forward}/\sigma_{reverse} \sim 10$, potentially enabling the creation of *ZT* > 5 thermoelectric materials which would fundamentally change the coefficient of performance of solid state materials, potentially opening up their use for all solid state commercial refrigeration systems.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

**Claims**

1.  A thermoelectric structure (10) comprising:

    a thin thermoelectric film extending in a plane between parallel first and second shorting bars (14, 16); and
    a plurality of curved ballistic scattering guides (26) formed in a magnetic field region (18) of the thin thermoelectric film subjected to a local, substantially uniform, nonzero magnetic field normal to the plane of the thin thermoelectric film; **characterized in that**
    the magnetic field is produced by a thin layer of magnetic material deposited at least atop or beneath the plane of the thin thermoelectric film, adjacent to the magnetic field region (18).

2.  The thermoelectric structure of claim 1, wherein the shape of the curved ballistic scattering guides (26) substantially matches an arc of curvature of a charge carrier travelling in a charge transport direction between the first shorting bar (14) and the second shorting bar (16) through the magnetic field region.

3.  The thermoelectric structure of claim 1, wherein the adjacent curved ballistic scattering guides (26) are separated by a distance of between 1nm and 1μm along an axis parallel to the first and second shorting bars (14, 16).

4.  The thermoelectric structure of claim 1, further comprising:

    a first plurality of collimating scattering guides (24) formed normal to the first and second shorting bars (14, 16) in a first collimating region (20) subjected to negligible magnetic fields between the first shorting bar (14) and the magnetic field region (18);
    a second plurality of collimating scattering guides (24) formed normal to the first and second shorting bars (16) in a second collimating region (22) subjected to negligible magnetic fields between the second shorting bar (16) and the magnetic field region (18).

5.  The thermoelectric structure of claim 4, wherein the curved ballistic scattering guides (26) and the collimating scattering guides (24) are formed by laser or mechanical scribing.

6. The thermoelectric structure of claim 4, wherein the curved ballistic scattering guides (26) and the collimating scattering guides (24) are formed by surface level or field doping.

7. The thermoelectric structure of claim 4, wherein the curved ballistic scattering guides (26) and the collimating scattering guides (24) are formed by lithographic patterning.

8. The thermoelectric structure of claim 4, wherein adjacent collimating ballistic scattering guides (24) are separated by a distance between 1nm and 1 $\mu$m along an axis parallel to the first and second shorting bars (14, 16).

9. The thermoelectric structure of claim 1, wherein the thin thermoelectric film has a thickness less than the electron mean free path in the thin thermoelectric film.

10. The thermoelectric structure of claim 1, wherein the curved ballistic scattering guides (26) extend through the entire thickness of the thin thermoelectric film.

11. The thermoelectric structure of claim 1, wherein the thin thermoelectric film is formed of a semi-metal.

12. The thermoelectric structure of claim 1, wherein the thin thermoelectric film is formed of a high-mobility semiconductor.

13. The thermoelectric structure of claim 12, wherein the thin thermoelectric film is formed of a graphene.

14. The thermoelectric structure of claim 1, wherein the first and second shorting bars (14, 16) are formed of a conducting layer of doped material.

**Patentansprüche**

1. Thermoelektrische Struktur (10), umfassend:

   einen dünnen thermoelektrischen Film, der sich in einer Ebene zwischen parallelen ersten und zweiten Kurzschlussbügeln (14, 16) erstreckt; und
   eine Vielzahl von gekrümmten ballistischen Streuungsführungen (26), die in einem Magnetfeldbereich (18) des thermoelektrischen Films gebildet sind, der einem örtlichen, im Wesentlichen gleichmäßigen Magnetfeld ungleich Null senkrecht zu der Ebene des dünnen thermoelektrischen Films ausgesetzt ist; **dadurch gekennzeichnet, dass**
   das Magnetfeld durch eine dünne Schicht von magnetischem Material hergestellt ist, die mindestens oberhalb oder unterhalb der Ebene des dünnen thermoelektrischen Films angrenzend an den Magnetfeldbereich (18) angeordnet ist.

2. Thermoelektrische Struktur nach Anspruch 1, wobei die Form der gekrümmten ballistischen Streuungsführungen (26) im Wesentlichen mit einem Krümmungsbogen eines Ladungsträgers übereinstimmt, der in einer Ladungstransportrichtung zwischen dem ersten Kurzschlussbügel (14) und dem zweiten Kurzschlussbügel (16) durch den Magnetfeldbereich läuft.

3. Thermoelektrische Struktur nach Anspruch 1, wobei die angrenzenden gekrümmten ballistischen Streuungsführungen (26) durch einen Abstand zwischen 1 nm und 1 $\mu$m entlang einer Achse parallel zu den ersten und zweiten Kurzschlussbügeln (14, 16) getrennt sind.

4. Thermoelektrische Struktur nach Anspruch 1, ferner umfassend:

   eine erste Vielzahl von kollimierenden Streuungsführungen (24), die senkrecht zu den ersten und zweiten Kurzschlussbügeln (14, 16) in einem ersten kollimierenden Bereich (20), der unerheblichen Magnetfeldern zwischen dem ersten Kurzschlussbügel (14) und dem Magnetfeldbereich (18) ausgesetzt ist, gebildet sind;
   eine zweite Vielzahl von kollimierenden Streuungsführungen (24), die senkrecht zu den ersten und zweiten Kurzschlussbügeln (16) in einem zweiten kollimierenden Bereich (22), der unerheblichen Magnetfeldern zwischen dem zweiten Kurzschlussbügel (16) und dem Magnetfeldbereich (18) ausgesetzt ist, gebildet sind.

5. Thermoelektrische Struktur nach Anspruch 4, wobei die gekrümmten ballistischen Streuungsführungen (26) und die kollimierenden Streuungsführungen (24) durch Laser oder mechanisches Ritzen gebildet sind.

6. Thermoelektrische Struktur nach Anspruch 4, wobei die gekrümmten ballistischen Streuungsführungen (26) und die kollimierenden Streuungsführungen (24) durch Oberflächen- oder Felddotierung gebildet sind.

7. Thermoelektrische Struktur nach Anspruch 4, wobei die gekrümmten ballistischen Streuungsführungen (26) und die kollimierenden Streuungsführungen (24) durch lithographische Strukturierung gebildet sind.

8. Thermoelektrische Struktur nach Anspruch 4, wobei angrenzende kollimierende ballistische Streuungsführungen (24) durch einen Abstand zwischen 1 nm und 1 $\mu$m entlang einer Achse parallel zu den ersten und zweiten Kurzschlussbügeln (14,16) getrennt sind.

9. Thermoelektrische Struktur nach Anspruch 1, wobei der dünne thermoelektrische Film eine Dicke aufweist, die geringer ist als die mittlere freie Weglänge für Elektronen in dem dünnen thermoelektrischen Film.

10. Thermoelektrische Struktur nach Anspruch 1, wobei sich die gekrümmten ballistischen Streuungsführungen (26) durch die gesamte Dicke des dünnen thermoelektrischen Films erstrecken.

11. Thermoelektrische Struktur nach Anspruch 1, wobei der dünne thermoelektrische Film aus einem Halbmetall gebildet ist.

12. Thermoelektrische Struktur nach Anspruch 1, wobei der dünne thermoelektrische Film aus einem Halbleiter mit hoher Beweglichkeit gebildet ist.

13. Thermoelektrische Struktur nach Anspruch 12, wobei der dünne thermoelektrische Film aus einem Graphen gebildet ist.

14. Thermoelektrische Struktur nach Anspruch 1, wobei die ersten und zweiten Kurzschlussbügel (14, 16) aus einer leitenden Schicht aus dotiertem Material gebildet sind.

**Revendications**

1. Structure thermoélectrique (10) comprenant :

une couche thermoélectrique mince s'étendant dans un plan entre des première et seconde tiges de court-circuit parallèles (14, 16) ; et
une pluralité de guides incurvés de dispersion balistique (26) formés dans une zone de champ magnétique (18) de la couche thermoélectrique mince soumise à un champ magnétique local,
sensiblement uniforme et non nul perpendiculaire au plan de la couche thermoélectrique mince ; **caractérisée en ce que** le champ magnétique est produit par une couche mince de matériau magnétique déposée au moins au-dessus ou en dessous du plan de la couche thermoélectrique mince, à proximité de la zone de champ magnétique (18).

2. Structure thermoélectrique selon la revendication 1, dans laquelle la forme des guides incurvés de dispersion balistique (26) correspond sensiblement à un arc de courbure d'un support de charge circulant dans une direction de transport de charge entre la première tige de court-circuit (14) et la seconde tige de court-circuit (16) au travers de la zone de champ magnétique.

3. Structure thermoélectrique selon la revendication 1, dans laquelle les guides incurvés de dispersion balistique adjacents (26) sont séparés par une distance comprise entre 1 nm et 1 $\mu$m le long d'un axe parallèle aux première et seconde tiges de court-circuit (14, 16).

4. Structure thermoélectrique selon la revendication 1, comprenant en outre :

une première pluralité de guides de dispersion à collimateur (24) formés perpendiculairement aux première et seconde tiges de court-circuit (14, 16) dans une première zone de collimation (20) soumise à des champs magnétiques négligeables entre la première tige de court-circuit (14) et la zone de champ magnétique (18) ;

une seconde pluralité de guides de dispersion à collimateur (24) formés perpendiculairement aux première et seconde tiges de court-circuit (16) dans une seconde zone de collimation (22) soumise à des champs magnétiques négligeables entre la seconde tige de court-circuit (16) et la zone de champ magnétique (18).

5. Structure thermoélectrique selon la revendication 4, dans laquelle les guides incurvés de dispersion balistique (26) et les guides de dispersion à collimateur (24) sont formés par gravure laser ou mécanique.

6. Structure thermoélectrique selon la revendication 4, dans laquelle les guides incurvés de dispersion balistique (26) et les guides de dispersion à collimateur (24) sont formés par dopage de surface ou de champ.

7. Structure thermoélectrique selon la revendication 4, dans laquelle les guides incurvés de dispersion balistique (26) et les guides de dispersion à collimateur (24) sont formés par texturation lithographique.

8. Structure thermoélectrique selon la revendication 4, dans laquelle des guides de dispersion balistique à collimateur adjacents (24) sont séparés par une distance comprise entre 1 nm et 1 $\mu$m le long d'un axe parallèle aux première et seconde tige de court-circuit (14, 16).

9. Structure thermoélectrique selon la revendication 1, dans laquelle la couche thermoélectrique mince a une épaisseur inférieure au libre parcours moyen d'un électron dans la couche thermoélectrique mince.

10. Structure thermoélectrique selon la revendication 1, dans laquelle les guides incurvés de dispersion balistique (26) s'étendent au travers de la totalité de l'épaisseur de la couche thermoélectrique mince.

11. Structure thermoélectrique selon la revendication 1, dans laquelle la couche thermoélectrique mince est formée d'un semi-métal.

12. Structure thermoélectrique selon la revendication 1, dans laquelle la couche thermoélectrique mince est formée d'un semi-conducteur à haute mobilité.

13. Structure thermoélectrique selon la revendication 12, dans laquelle la couche thermoélectrique mince est formée d'un graphène.

14. Structure thermoélectrique selon la revendication 1, dans laquelle les première et seconde tiges de court-circuit (14, 16) sont formées d'une couche conductrice de matériau dopé.

**Fig. 1**

**Fig. 2A**

**Fig. 2B**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100044644 A1
- EP 2157625 A